# EUROPÄISCHE PATENTSCHRIFT

(11) **EP 2 375 516 B1**
(45) Veröffentlichungstag und Bekanntmachung des Hinweises auf die Patenterteilung: **05.06.2024**
(21) Anmeldenummer: 11002780.2
(22) Anmeldetag: 02.04.2011
(51) Int. Cl.: H02B 1/03, G01R 22/06, H01R 4/30, H01R 9/24

(54) **Vorrichtung zum Anschliessen von elektrischen Leitungen an einem elektronischen Haushaltszähler oder Adapter**
Device for connecting electrical cables to an electronic houshold meter or adapter
Dispositif de raccordement de lignes électriques à un compteur domestique électronique ou adaptateur

(30) Priorität: 08.04.2010 DE 202010004693 U
(43) Veröffentlichungstag der Anmeldung: 12.10.2011
(73) Patentinhaber: ABN GmbH, 74196 Neuenstadt (DE)
(72) Erfinder: Braun, Werner, 74906 Bad Rappenau (DE); Schmiederer, Roland, 77876 Kappelrodeck (DE)
(74) Vertreter: Gleim Petri Patent- und Rechtsanwaltspartnerschaft mbB

(56) Entgegenhaltungen:
- EP-A2- 2 120 055
- AU-A4- 2009 100 471
- DE-A1- 10 216 913
- DE-U1-202009 009 265

## Beschreibung

### TECHNISCHES GEBIET

Die Erfindung betrifft eine Vorrichtung zum Anschließen von elektrischen Leitungen an einem elektronischen Haushaltszähler. Ein elektronischer Haushaltszähler kann elektronische Verbrauchsinformationen erfassen, abrufbereit speichern und anzeigen.

Solche elektronischen Haushaltszähler (eHZ) lösen im Zuge des Wandels im Energiemarkt den bisherigen mechanischen Ferraris-Zähler ab. Der elektronische Haushaltszähler soll den Privat- und Gewerbekunden durch zeitnahe Verbrauchsinformationen und variable Tarife für den bewussten Umgang mit der Energie sensibilisieren. Sowohl die Privat- und Gewerbekunden als auch die Energieversorger können einen solchen Zähler in einem wesentlich größeren Umfang nutzen, als es mit dem altbekannten Ferraris-Zähler der Fall ist.

### STAND DER TECHNIK

Es ist eine Kommunikationseinrichtung (MUC) als Verbindungseinrichtung zwischen einem elektronischen Haushaltszähler und dem jeweiligen Kunden und dem Betreiber eines elektronischen Haushaltszählers bekannt. Eine solche Kommunikationseinrichtung erweitert das Nutzenspektrum eines solchen elektronischen Haushaltszählers dadurch, dass sie einerseits dem Kunden und dem Betreiber des elektronischen Zählers verbrauchsrelevante Daten zur Verfügung stellen und andererseits dem Betreiber darüber hinaus eine Kommunikation mit dem elektronischen Haushaltszähler in beiden Richtungen ermöglichen kann.

Eine solche Kommunikationseinrichtung kann in einem elektronischen Zähler integriert vorhanden sein. Es ist darüber hinaus bekannt, den elektronischen Haushaltszähler an einem Adapter anzudocken, der dann seinerseits mit der Kommunikationseinrichtung ausgestattet ist. Der Anschluss der elektrischen Leitungen an dem elektronischen Haushaltszähler erfolgt dann entweder direkt in den elektronischen Haushaltszähler hinein und aus demselben heraus, oder bei Vorhandensein des vorstehend genannten Adapters in den Adapter hinein und aus demselben heraus. Bei Vorhandensein einer Kommunikationseinrichtung kann auch diese von den angeschlossenen elektrischen Leitungen mit elektrischer Spannung versorgt werden.

Relevanter Stand der Technik ist in EP 2 120 055 A2, AU 2009 100 471 A4, DE 102 16 913 A1 und DE 20 2009 009265 U1 offenbart.

### DARSTELLUNG DER ERFINDUNG

Ausgehend von diesem Stand der Technik liegt der Erfindung die Aufgabe zugrunde, die Vorrichtung zum Anschließen der elektrischen Leitungen an den elektrischen Haushaltszähler so auszubilden, dass diese Anschließvorrichtung möglichst universal eingesetzt werden kann und damit möglichst viele elektrische Energie verbrauchende Geräte mit elektrischer Spannung versorgt werden können.

Diese Erfindung wird durch die Merkmale des Hauptanspruches gelöst. Sinnvolle Weiterbildungen der Erfindung sind Gegenstand von sich daran anschließenden weiteren Ansprüchen.

Die Erfindung beinhaltet, dass eine Phasenabgriffseinrichtung an den angeschlossenen Leitungen der Anschließvorrichtung vorhanden ist, und zwar zumindest an einer Zugangsleitung als auch an zumindest einer Abgangsleitung. Der durch die Zugangsleitungen zugeführte Strom ist noch nicht durch den elektronischen Haushaltszähler erfasst und damit gezählt. Der Phasenabgriff erfolgt also noch beim ungezählten elektrischen Strom. Andererseits ist es möglich, alternativ oder zusätzlich dazu auch Abgangsleitungen mit dem bereits vom elektrischen Zähler gezählten Strom abzugreifen. Beliebige Zusatzgeräte beziehungsweise elektrische Verbraucher können also sowohl mit ungezähltem als auch mit gezähltem Strom versorgt werden. Falls der Kunde irgendwelche elektrischen Verbraucher, wie beispielsweise häusliche Computer, zur optischen Erfassung und Darstellung der durch den elektrischen Zähler erfassten Verbrauchswerte gespeichert haben und sich anzeigen lassen möchte, wird er seinen beispielsweise Computer an die Abgangsleitungen, die den gezählten Strom führen, anschließen. Sollte der Energieversorger irgendwelche elektronischen Zusatzgeräte anschließen wollen, wird er diese Geräte an die Zugangsleitungen anschließen, die noch ungezählten Strom führen. Der Kunde wird dann durch die verbrauchte elektrische Leistung dieser Geräte nicht kostenmäßig belastet.

Eine derartige Phasenabgriffseinrichtung ist an jeder Zugangs- und Abgangsleitung vorhanden. Es können dann auch mehrere elektrische beziehungsweise elektronische Geräte mit zweiphasigem oder dreiphasigem elektrischem Strom versorgt werden.

Die einzelnen Phasenabgriffseinrichtungen sind als Schraubklemmen ausgebildet, wie es im Ausführungsbeispiel dargestellt ist.

Die Anschließvorrichtung kann bei Vorhandensein eines Adapters, der am elektronischen Haushaltszähler anschließbar ist, bereits fest angeschlossen sein. Der Adapter und die Anschließvorrichtung können in diesem Zusammenhang einteilig miteinander verbunden werden. Es ist auch möglich, die Anschließvorrichtung als separates Bauteil an den genannten Adapter anzuschließen. Die Anschließvorrichtung könnte dann ein modulartiges, vom Adapter losgelöstes Bauteil sein.

Die Anschließvorrichtung kann auch an einem elektronischen Haushaltszähler unmittelbar angeschlossen sein und mit demselben dann integriert vorhanden sein. Es ist auch möglich, die Anschließvorrichtung wiederum als separates Bauteil modulartig an dem elektronischen Haushaltszähler anzuschließen.

Bei Vorhandensein einer Kommunikationseinrichtung für den elektronischen Haushaltszähler kann die Anschließvorrichtung auch an einer solchen Kommunikationseinrichtung bereits angeschlossen sein. Die Anschließvorrichtung und die Kommunikationseinrichtung können dann beispielsweise einteilig miteinander verbunden sein. Es ist auch möglich, die Anschließvorrichtung modulartig an der Kommunikationseinrichtung anzuzschließen.

Die Anschließvorrichtung kann darüber hinaus mehrere Anschlussklemmen aufweisen, mittels derer eine zusätzliche Verbindung zu einem Adapter hergestellt werden kann. Alternativ oder zusätzlich dazu können auch Leitungsverbindungen zu der bereits erwähnten Kommunikationseinrichtung hergestellt werden, sofern eine solche zwischen dem elektronischen Haushaltszähler und einem Kunden oder Betreiber dieses Zählers vorgesehen ist.

Gemäß einem in der Zeichnung dargestellten Ausführungsbeispiel sind drei Anschlussklemmen vorhanden. Eine Anschlussklemme ist für eine Phasenleitung und zwei Anschlussklemmen für zwei Signalleitungen vorgesehen.

Darüber hinaus kann eine Schnittstelle an der Anschließvorrichtung vorhanden sein, die beispielsweise als eine RJ10-Buchse ausgebildet ist und die zum Ansteuern einer am elektronischen Haushaltszähler oder an seinem Adapter vorhandenen Kommunikationsschnittstelle dient. Diese Kommunikationsschnittstelle kann beispielsweise als optische Schnittstelle ausgebildet sein.

Nähere Einzelheiten zu der erfindungsgemäßen Anschließvorrichtung für elektrische Leitungen und weitere Vorteile und Merkmale der Erfindung sind den in den Ansprüchen ferner angegebenen Merkmalen sowie dem nachstehenden Ausführungsbeispiel zu entnehmen.

### KURZE BESCHREIBUNG DER ZEICHNUNG

Die Erfindung wird im Folgenden anhand der in der Zeichnung dargestellten Ausführungsbeispiele näher beschrieben und erläutert. Es zeigen:
- Fig. 1: eine perspektivische Darstellung eines mit einer erfindungsgemäßen Anschließvorrichtung für elektrische Leitungen ausgestatteten Adapters mit an ihm angedocktem, elektrischem Haushaltszähler,
- Fig. 2: eine vergrößerte Teilansicht der Anschließvorrichtung gemäß Fig. 1.

### WEGE ZUM AUSFÜHREN DER ERFINDUNG

Ein Adapter 10, an dem ein elektronischer Haushaltszähler 12 kontaktmäßig angedockt ist, ist zur Befestigung an einem Dreipunktzählerkreuz vorgesehen, das in der Zeichnung nicht dargestellt ist und das üblicherweise zum Befestigen von Ferraris-Zählern verwendet wird.

Zum Befestigen des elektronischen Haushaltszählers 12 an dem vorstehend genannten Dreipunktzählerkreuz besitzt der Adapter 10 eine mittige obere als Langloch ausgebildete Durchgangsöffnung 13, durch die hindurch die in der Zeichnung angedeutete obere standardisierte Befestigungsöffnung 14 eines Dreipunktzählerkreuzes zugänglich ist.

Seitlich unten am Adapter 10, und dort im Bereich der an ihm im vorliegenden Beispielsfall einstückig vorhandenen Anschließvorrichtung 15, die als Anschlussklemmenblock bezeichnet wird und in der die Zugangs- und Abgangsleitungen für die elektrische Spannungsversorgung des Adapters 10 in den Adapter hinein und aus demselben herausgeführt werden, ist jeweils rechts und links ein seitlicher Befestigungsschlitz 17 vorhanden, von denen in der Zeichnung der rechte Befestigungsschlitz 17 erkennbar ist. Diese sogenannte Dreipunktbefestigung für einen Adapter 10 ist an sich bekannt.

In dem Adapter 10 ist oberhalb des Bereiches, wo der elektronische Haushaltszähler 12 angedockt ist, eine aus einem linken Modulteil 20 und einem rechten Modulteil 22 bestehende Kommunikationseinrichtung (MUC) angeordnet. Diese beiden Modulteile 20, 22 sind in den Adapter 10 eingesetzt vorhanden. Die beiden Modulteile 20, 22 können auch als einteiliges Modul ausgebildet und in den Adapter 10 eingesetzt vorhanden sein.

In dem linken Modulteil 20 ist eine für den Weitverkehr vorgesehene GPS-Schnittstelle 24 vorhanden. In dem rechten Modulteil 22 sind für den Nahverkehr vorgesehene Schnittstellen in Form einer USB-Buchse 26 und einer RJ45-Buchse 28 vorhanden. Zusätzlich ist im linken Modulteil 20 noch ein Reset- oder Menü-Knopf 30 vorhanden, über den Softwarebefehle in das linke Modulteil 20 hinein eingegeben werden können. Über zwei beziehungsweise vier LED's 32 beziehungsweise 34 kann der Betrieb des jeweiligen linken beziehungsweise rechten Modulteils 20, 22 angezeigt und überwacht werden.

Im unteren Bereich des Adapters 10, und mit diesem einteilig verbunden, ist die Anschließvorrichtung 15 angeordnet. Die Anschließvorrichtung 15 kann auch als separates Bauteil an dem Adapter 10 beispielsweise angedockt oder auf sonstige Weise mit diesem elektrisch verbunden werden.

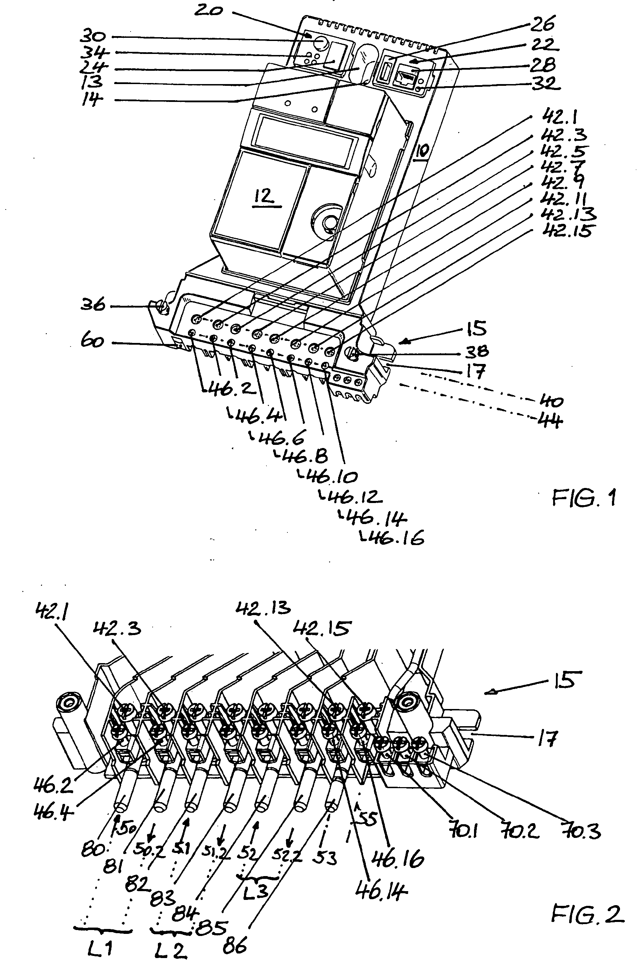

Die Anschließvorrichtung 15 ist normalerweise durch eine Abdeckung verschlossen und damit von außen nicht zugänglich. Die Abdeckung wird dann regelmäßig durch eine Verplombung vor unbefugtem Zugriff gesichert. Im vorliegenden Fall ist eine diesbezügliche linke und rechte Plombierschraube 36, 38 in Fig. 1 dargestellt.

In der Anschließvorrichtung 15 sind in einer oberen Reihe 40 acht Schraubklemmen 42 (42.1, 42.3, 42.5, 42.7, 42.9, 42.11, 42.13, 42.15) dargestellt. In einer parallelen unteren Reihe 44 sind acht Schraubklemmen 46 (46.2, 46.4, 46.6, 46.8, 46.10, 46.12, 46.14, 46.16) dargestellt (Fig. 1).

Die oberen acht Schraubklemmen 42 (42.1, 42.3, 42.5, 42.7, 42.9, 42.11, 42.13, 42.15) dienen zur Befestigung von Zugangs- und Abgangsleitungen, die zu den Kontakten des Adapters 10 hinein beziehungsweise von Kontakten des Adapters 10 herausgeführt werden. In allen Zugangsleitungen ist ungezählter und in allen Abgangsleitungen gezählter Strom vorhanden. An der Schraubklemme 42.1 ist die Zugangsleitung 50 und an der Schraubklemme 42.3 die Abgangsleitung 50.2 der ersten Leitungsader L1 einer dreiadrigen Starkstrom-Versorgungsleitung dargestellt. In entsprechender Weise sind die Zugangsleitung 51 und die Abgangsleitung 51.2 der zweiten Ader L2 dieser dreiadrigen Versorgungsleitung über die Schraubklemmen 42.5 beziehungsweise 42.7 an der Anschließvorrichtung 15 befestigt. Über die Schraubklemmen 42.9 und 42.11 sind in entsprechender Weise die Zugangsleitung 52 und die Abgangsleitung 52.2 der dritten Ader L3 der dreiadrigen Versorgungsleitung an der Anschließvorrichtung 15 befestigt. An einer weiteren Schraubklemme 42.13 ist der Neutralleiter 53 dieser dreiadrigen Versorgungsleitung angeschlossen. Die noch im Neutralleiter 53 vorhandene Schraubklemme 42.15 eröffnet die Möglichkeit, einen weiteren Neutralleiter 55 an der Anschließvorrichtung 15 zu befestigen, um denselben dann beispielsweise durch den Adapter hindurchschleifen zu können.

Den in der oberen Reihe 40 vorhandenen acht Schraubklemmen 42 sind in der unteren Reihe 44 acht Schraubklemmen 46 vorgelagert. In jeder dieser acht Schraubklemmen 46.2, 46.4, 46.6, 46.8, 46.10, 46.12, 46.14, 46.16 können an den entsprechenden Zugangsleitungen 50, 51, 52 beziehungsweise Abgangsleitungen 50.2, 51.2, 52.2 und den beiden Neutralleitern 53, 55 jeweils zusätzliche Leitungen angeschlossen werden. Damit ist ein zusätzlicher Phasenabgriff für eine beliebige externe Spannungsversorgung, wie zum Beispiel für Schaltuhren, Steuergeräte für eine Tarifansteuerung oder sonstige Geräte möglich.

Zusätzlich ist in der in der Figur linken unteren Seite der Anschließvorrichtung 15 Platz für eine RJ10-Buchse 60, über die eine Verbindung zu einer in der Zeichnung nicht dargestellten optischen Schnittstelle hergestellt werden kann, die auf dem Adapter 10 ausgebildet ist und über die mit dem elektronischen Haushaltszähler 12 eine Kommunikation möglich ist.

Auf der rechten unteren Seite der Anschließvorrichtung 15 sind drei weitere Schraubklemmen 70.1, 70.2, 70.3 vorhanden, über die drei Leitungsadern, die in den Adapter 10 hineingeführt werden, anschließbar sind. Eine dieser Klemmschrauben 70.1 kann als Anschlussklemme für eine Phasenleitung verwendet werden. Die beiden anderen Klemmschrauben 70.2, 70.3 können zum Anschließen von zwei Signalleitungen benutzt werden, um beispielsweise den elektronischen Haushaltszähler 12 ansteuern zu können im Zusammenhang mit Tarifumschaltungen und zum Übertragen von Schaltuhrsignalen und anderen Kommandosignalen.

Aus der Anschließvorrichtung 15 ragen - in Fig. 2 - nach unten sieben Kontaktstifte 80, 81, 82, 83, 84, 85, 86 heraus, die verbunden sind mit sieben Schraubklemmen 42.1, 42.3, 42.5, 42.7, 42.9, 42.11, 42.13 der oberen Reihe 40. Damit lässt sich die Anschließvorrichtung 15 an einer sogenannten Zählersteckklemme anstecken, wie sie in auf dem Markt vorhandenen Bestandsanlagen regelmäßig vorhanden ist. An diese an sich bekannte Zählersteckklemme kann dann über die drei Adern L1, L2, L3 und den Neutralleiter 53 mittels eines Überbrückungssteckers die unterbrechungsfreie Stromversorgung der an dem Adapter angeschlossenen Verbraucher gewährleistet werden, und zwar auch dann, wenn der elektronische Haushaltszähler nicht an dem Adapter angedockt ist. Die in der Zeichnung nicht dargestellte verplombbare Abdeckung der Anschließvorrichtung kann dann so groß ausgelegt werden, dass sie auch die Zählersteckklemme mit abdeckt und damit absichert.

## Patentansprüche

1. Adapter (10)
- mit einem elektrische Verbrauchsinformationen erfassenden, abrufbereit speichernden und anzeigenden elektronischen Haushaltszähler (12),
- mit einer Vorrichtung (15) zum Anschließen von elektrischen Leitungen an den Haushaltszähler (12),
- wobei die Anschließvorrichtung (15) drei zum Zähler (12) führende Zugangsleitungen (50, 51, 52), drei vom Zähler (12) kommende Abgangsleitungen (50.2, 51.2, 52.2) und zwei Neutralleiter (53, 55) aufweist, die jeweils über Schraubklemmen (42.1, 42.3, 42.5, 42.7, 42.9, 42.11, 42.13, 42.15) an der Vorrichtung (15) befestigt sind,
- wobei an allen Zugangs- und Abgangsleitungen jeweils Phasenabgriffseinrichtungen (46.2, 46.4, 46.6, 46.8, 46.10, 46.12, 46.14, 46.16) vorhanden sind, die jeweils als Schraubklemmen (46.2, 46.4, 46.6, 46.8, 46.10, 46.12, 46.14, 46.16) ausgebildet sind,
- **dadurch gekennzeichnet, dass**
- die Schraubklemmen (42.1, 42.3, 42.5, 42.7, 42.9, 42.11, 42.13, 42.15) der Zugangs- und Abgangsleitungen in einer zum Zähler (12) weisenden oberen Reihe (40) angeordnet sind,
- die Phasenabgriffseinrichtungen (46.2, 46.4, 46.6, 46.8, 46.10, 46.12, 46.14, 46.16) in einer zur oberen Reihe (40) parallelen, vom Zähler (12) weg weisenden unteren Reihe (44) angeordnet sind.

2. Adapter nach Anspruch 1,
- **dadurch gekennzeichnet, dass**
- die Anschließvorrichtung unmittelbar an dem Haushaltszähler anschließbar oder an demselben angeschlossen ist.

3. Adapter nach Anspruch 2,
- **dadurch gekennzeichnet, dass**
- Anschließvorrichtung und Zähler einteilig miteinander verbunden sind.

4. Adapter nach einem der vorstehenden Ansprüche,
- **dadurch gekennzeichnet, dass**
- eine Kommunikationseinrichtung (20, 22) zur automatisierten Messdatenerfassung anschließbar oder angeschlossen ist.

5. Adapter nach Anspruch 4,
- **dadurch gekennzeichnet, dass**
- die Kommunikationseinrichtung und die Anschließvorrichtung einteilig miteinander verbunden sind.

6. Adapter nach Anspruch 1,
- **dadurch gekennzeichnet, dass**
- mehrere Anschlussklemmen (70.1, 70.2, 70.3) zum Herstellen von Leitungsverbindungen von der Anschließvorrichtung (15) zu dem Adapter (10) und/oder zu einer zwischen dem elektronischen Haushaltszähler und einem Kunden oder Betreiber dieses Zählers anzuordnenden Kommunikationseinrichtung vorhanden sind.

7. Adapter nach Anspruch 6,
- **dadurch gekennzeichnet, dass**
- eine Anschlussklemme (70.1) für eine Phasenleitung und zwei Anschlussklemmen (70.2, 70.3) für zwei Signalleitungen vorhanden sind.

8. Adapter nach Anspruch 1 oder 7,
- **dadurch gekennzeichnet, dass**
- eine Schnittstelle wie insbesondere eine RJ10-Buchse (60) zum Ansteuern einer Kommunikationsschnittstelle am Adapter beziehungsweise am elektronischen Haushaltszähler vorhanden ist.

## Claims

1. Adapter (10)
- having an electronic household meter (12) that acquires, stores in ready-to-retrieve form and displays electrical consumption information,
- having an apparatus (15) for connecting electrical lines to the household meter (12),
- the connecting apparatus (15) having three incoming feeders (50, 51, 52) leading to the meter (12), three outgoing feeders (50.2, 51.2, 52.2) coming from the meter (12) and two neutral conductors (53, 55), which are each mounted on the apparatus (15) using screw terminals (42.1, 42.3, 42.5, 42.7, 42.9, 42.11, 42.13, 42.15),
- all of the incoming and outgoing feeders having respective phase devices (46.2, 46.4, 46.6, 46.8, 46.10, 46.12, 46.14, 46.16) on them, which are each in the form of screw terminals (46.2, 46.4, 46.6, 46.8, 46.10, 46.12, 46.14, 46.16),
- **characterized in that**
- the screw terminals (42.1, 42.3, 42.5, 42.7, 42.9, 42.11, 42.13, 42.15) of the incoming and outgoing feeders are arranged in an upper row (40) that points towards the meter (12),
- the phase tap devices (46.2, 46.4, 46.6, 46.8, 46.10, 46.12, 46.14, 46.16) are arranged in a lower row (44), parallel to the upper row (40), that points away from the meter (12).

2. Adapter according to Claim 1,
- **characterized in that**
- the connecting apparatus is connectable to the household meter, or connected thereto, directly.

3. Adapter according to Claim 2,
- **characterized in that**
- the connecting apparatus and the meter are integrally connected to one another.

4. Adapter according to one of the preceding claims,
- **characterized in that**
- a communication device (20, 22) for automated measurement data acquisition is connectable or connected.

5. Adapter according to Claim 4,
- **characterized in that**
- the communication device and the connecting apparatus are integrally connected to one another.

6. Adapter according to Claim 1,
- **characterized in that**
- there are multiple connecting terminals (70.1, 70.2, 70.3) for making line connections from the connecting apparatus (15) to the adapter (10) and/or to a communication device that can be arranged between the electronic household meter and the customer or operator of this meter.

7. Adapter according to Claim 6,
- **characterized in that**
- there are one connecting terminal (70.1) for a phase line and two connecting terminals (70.2, 70.3) for two signal lines.

8. Adapter according to Claim 1 or 7,
- **characterized in that**
- there is an interface, such as in particular an RJ10 socket (60), for controlling a communication interface on the adapter or on the electronic household meter.

## Revendications

1. Adaptateur (10) comprenant
- un compteur domestique électronique (12) qui acquiert des informations de consommation électrique, les mémorise de manière récupérable et les affiche,
- un dispositif (15) de raccordement de lignes électriques au compteur domestique (12),
- un dispositif de raccordement (15) comportant trois lignes d'entrée (50, 51, 52) menant au compteur (12), trois lignes de sortie (50.2, 51.2, 52.2) provenant du compteur (12) et deux conducteurs neutres (53, 55) qui sont chacun fixés au dispositif (15) par le biais de bornes à vis (42.1, 42.3, 42.5, 42.7, 42.9, 42.11, 42.13, 42.15),
- des modules de prise de phase (46.2, 46.4, 46.6, 46.8, 46.10, 46.12, 46.14, 46.16) étant prévus sur toutes les lignes d'entrée et de sortie , lesquels modules sont chacun conçus comme des bornes à vis (46.2, 46.4, 46.6, 46.8, 46.10, 46.12, 46.14, 46.16),
- **caractérisé en ce que**
- les bornes à vis (42.1, 42.3, 42.5, 42.7, 42.9, 42.11, 42.13, 42.15) des lignes d'entrée et de sortie sont disposées dans une rangée supérieure (40) dirigée vers le compteur (12),
- les modules de prise de phase (46.2, 46.4, 46.6, 46.8, 46.10, 46.12, 46.14, 46.16) sont disposés dans une rangée inférieure (44) parallèle à la rangée supérieure (40) et dirigée à l'opposé du compteur (12).

2. Adaptateur selon la revendication 1,
- **caractérisé en ce que**
- le dispositif de raccordement est raccordé, ou peut être raccordé, directement au compteur domestique.

3. Adaptateur selon la revendication 2,
- **caractérisé en ce que**
- le dispositif de raccordement et le compteur sont reliés l'un à l'autre d'une seule pièce.

4. Adaptateur selon l'une des revendications précédentes,
- **caractérisé en ce que**
- un dispositif module de communication (20, 22) est raccordé ou peut être raccordé pour acquérir de manière automatisée des données de mesure.

5. Adaptateur selon la revendication 4,
- **caractérisé en ce que**
- le module de communication et le dispositif de raccordement sont reliés l'un à l'autre d'une seule pièce.

6. Adaptateur selon la revendication 1,
- **caractérisé en ce que**
- plusieurs bornes de raccordement (70.1, 70.2, 70.3) sont prévues pour établir des liaisons de lignes depuis le dispositif de raccordement (15) vers l'adaptateur (10) et/ou vers un module de communication à disposer entre le compteur domestique électronique et un client ou un opérateur de ce compteur.

7. Adaptateur selon la revendication 6,
- **caractérisé en ce que**
- une borne de raccordement (70.1) est prévue pour une ligne de phase et deux bornes de raccordement (70.2, 70.3) sont prévues pour deux lignes de signal.

8. Adaptateur selon la revendication 1 ou 7,
- **caractérisé en ce que**
- une interface telle que notamment une prise femelle RJ10 (60) est prévue pour piloter une interface de communication sur l'adaptateur ou sur le compteur domestique électronique.
